# EUROPÄISCHE PATENTSCHRIFT

(11) **EP 1 842 393 B1**
(45) Veröffentlichungstag und Bekanntmachung des Hinweises auf die Patenterteilung: **28.03.2012**
(21) Anmeldenummer: 06703653.3
(22) Anmeldetag: 24.01.2006
(51) Int. Cl.: H05B 3/26, H05B 3/28, H05K 1/02

(54) **LEITERPLATTE ODER PLATINE MIT HEIZDRAHT**
PRINTED CIRCUIT BOARD OR CARD COMPRISING A HEATING WIRE
CARTE DE CIRCUITS IMPRIMES A FIL DE CHAUFFAGE

(30) Priorität: 24.01.2005 DE 202005001163 U
(43) Veröffentlichungstag der Anmeldung: 10.10.2007
(73) Patentinhaber: JUMATECH GmbH, 90542 Eckental (DE)
(72) Erfinder: WÖLFEL, Markus, 90542 Eckental (DE)
(74) Vertreter: Grünecker, Kinkeldey, Stockmair & Schwanhäusser
(86) Internationale Anmeldenummer: PCT/EP2006/000614
(87) Internationale Veröffentlichungsnummer: WO 2006/077165

(56) Entgegenhaltungen:
- AU-B2- 728 378
- US-A- 3 440 407
- US-A- 6 114 674
- US-A1- 2002 162 829
- US-A1- 2004 075 528
- PATENT ABSTRACTS OF JAPAN Bd. 2000, Nr. 06, 22. September 2000 (2000-09-22) -& JP 2000 091714 A (SAKANO KAZUHITO), 31. März 2000 (2000-03-31)

## Beschreibung

Die Erfindung geht aus von einer Leiterplatte oder Platine mit elektrischer Schaltung gemäß dem Oberbegriff des Anspruchs 1.

Dokument US 6 114 674 A beschreibt eine zweischichtige Platine mit einer Heizeinrichtung. Die Heizeinrichtung besteht aus einem Widerstandsdraht der von einer Spannungsquelle mit Strom versorgt wird.

Die AU 7 28 378 B2 zeigt ein Verfahren und eine Anordnung zur Heizung eines Elements auf einer Leiterplatte. Dabei werden die vorhandenen Leiterbahnen als Widerstand zur Beheizung verwendet.

In der JP 2000091714 A wird ein selbstgesteuertes Kaltleiter-Element auf eine Leiterplatte befestigt, damit die Temperatur von anderen Bauelementen beeinflusst werden kann.

Druckschrift US 3 440 407 A beschreibt eine Leiterplatte mit eingebetteten Heizelementen die im wesentlichen gittermusterförmig angeordnet sind. Zur Regulierung der Temperatur ist zusätzlich ein Thermostat auf der Oberfläche der Leiterplatte angebracht.

Die US 2004/075528 A1 beschreibt die Herstellung von dünnen Heizelementen für Leiterplatinen. Die Heizelemente bestehen jeweils aus einer Folie, die mit dünnen Metallbahnen beschichtet ist.

Das Dokument US 2002/162829 A1 offenbart eine Leiterplatte mit einer Heizeinrichtung. Hierbei ist die Heizeinrichtung in ein Substrat eingebettet welches Bestandteil der Leiterplatte ist.

Wenn solche Leiterplatten in elektrischen Vorrichtungen angeordnet sind, die sich im Freien befinden, sind sie oft stark wechselnden Temperaturen ausgesetzt. Dies kann zur Bildung von Kondenswasser und folglich zu Kurzschlüssen innerhalb der elektrischen Schaltung führen. Weiterhin kann sich die Leiterplatte den schwankenden Temperaturen gemäß unterschiedlich ausdehnen, was Kurzschlüsse bzw. Kontaktunterbrechungen bei der elektrischen Schaltung hervorrufen kann.

Der vorliegenden Erfindung liegt demzufolge die Aufgabe zugrunde, eine Leiterplatte oder Platine der eingangs erwähnten Art derart weiter zu entwickeln, dass die oben beschriebenen Nachteile vermieden werden.

Erfindungsgemäß wird diese Aufgabe durch die Merkmale des Patentanspruchs 1 gelöst.

Die Erfindung basiert auf dem Gedanken, auf oder innerhalb der Leiterplatte oder Platine zumindest einen elektrisch leitfähigen und isolierten, mit einer Spannungsquelle in Verbindung bringbaren Heizungsdraht anzuordnen. Dadurch kann die Platine oder die Leiterplatte durch Beheizung ständig auf einer definierten Temperatur gehalten werden. Die Höhe dieser Temperatur wird auf den Einzelfall abgestimmt und soll die Funktion der elektrischen Schaltung und insbesondere deren elektrischer und elektronischer Bauelemente nicht beeinträchtigen. Durch die Beheizung wird eine Bildung von Kondenswasser und von stark wechselnder Wärmedehnung der Leiterplatte oder Platine weitgehend vermieden, so dass die Störanfälligkeit der Schaltung in vorteilhafter Weise sinkt.

Vorteilhafte Ausgestaltungen sind in den Unteransprüchen angegeben.

Der Heizungsdraht wird durch Drahtschreibung auf der Leiterplatte oder Platine befestigt. Während Leiterbahnen auf Platinen oder Leiterplatten üblicherweise durch ein Ätzverfahren hergestellt werden, d.h. von einer auf einer Trägerplatte aufgebrachten Kupferfolie werden zwischen den gewünschten Leiterbahnen liegenden Bereiche abgeätzt, werden bei drahtgeschriebenen Leiterplatten oder Platinen Leitungsdrähte aus elektrisch leitfähigern Material zwischen auf der Platine angeordneten Anschlussstellen der Platine verlegt und beispielsweise zusammen mit der Platine in Verbundbauweise in einen Block aus Isoliermasse eingegossen. Ein Verfahren zur Herstellung einer solchen drahtgeschriebenen Leiterplatte oder Platine ist beispielsweise aus der DE 196 18 917 C1 bekannt.

Eine besonders gleichmäßige Temperaturverteilung ergibt sich, wenn sich der Heizungsdraht im wesentlichen über die gesamte Fläche der Leiterplatte oder Platine mäanderförmig erstreckt.

Besonders bevorzugt wird der Heizungsdraht durch einen Widerstandsdraht gebildet und verbindet auf der Leiterplatte oder Platine angeordnete Anschlussstellen für die Spannungsquelle miteinander.

Nachstehend ist ein Ausführungsbeispiel der Erfindung in den Zeichnungen dargestellt und in der nachfolgenden Beschreibung näher erläutert. Es zeigen:

| | |
|---|---|
| Fig. 1 | eine perspektivische Ansicht auf eine Leiterplatte, auf welche gemäß eines ersten Fertigungsschritts ein elektrisch leitender Heizungsdraht aufgebracht wird; |
| Fig. 2 | eine perspektivische Ansicht auf die Leiterplatte von Fig. 1 mit dem elektrisch leitenden Heizdraht, auf welche eine deckende Isolationsschicht gemäß eines weiteren Fertigungsschrittes aufgebracht wird; |
| Fig. 3 | eine perspektivische Ansicht auf die Leiterplatte von Fig. 1 in fertig gestelltem Zustand. |

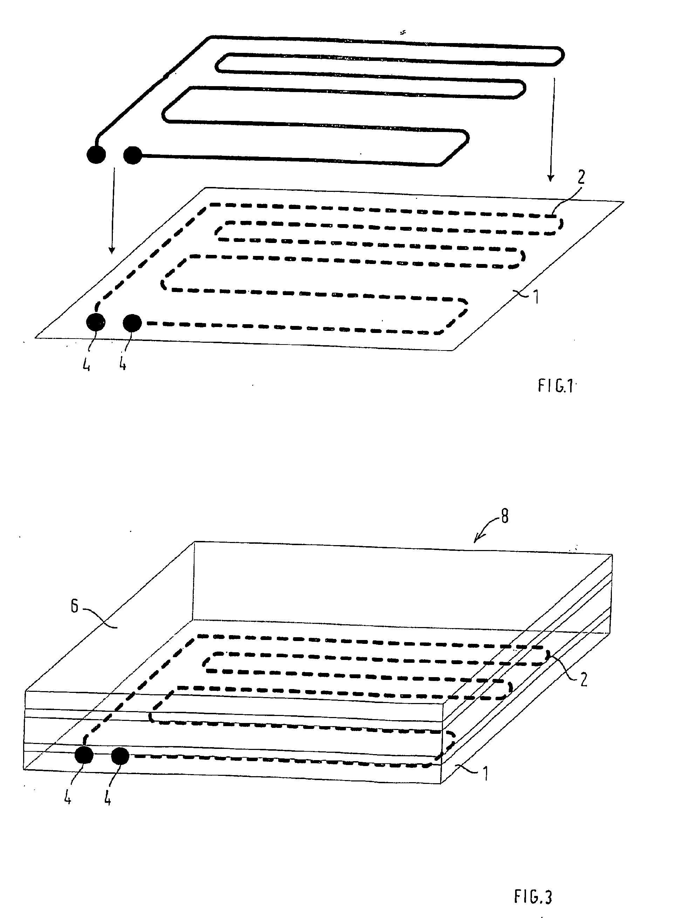

Die in Fig. 1 insgesamt mit 1 bezeichnete, elektrisch isolierende Leiterplatte ist bevorzugt eine geätzte Leiterplatte, d.h. auf ihrer Oberfläche befinden sich flache, vorzugsweise durch Ätzung hervorgegangene Leiterbahnen aus Kupfer, welche eine elektrische Schaltung ausbilden, die aus Übersichtlichkeitsgründen nicht dargestellt sind.

Gemäß eines ersten, in Fig. 1 schematisch gezeigten Fertigungsschritts wird beispielsweise ein elektrisch leitfähiger Leiterdraht in Form eines Heizungswiderstandsdrahts 2 durch Drahtschreibung auf die Leiterplatte 1 aufgebracht. Im vorliegenden Fall ist folglich auf der Leiterplatte 1 eine Kombination von geätzten Leiterbahnen mit einem Heizungswiderstandsdraht 2 verwirklicht.

Bei dem Draht handelt es sich um einen Draht mit einer elektrischen Isolierschicht.. Ein elektrisch isolierter Draht eignet sich insbesondere zum mäanderförmigen Verlegen des Heizdrahtes, wenn der Heizdraht und die Leiterbahnen auf der gleichen Seite der Leiterplatte angeordnet sind. Auf diese Weise kann die Herstellung vereinfacht und ein ungewollter elektrischer Kontakt zwischen Heizdraht und Leiterbahn vermieden werden Vorzugsweise kreuzt sich die Leiterbahn und der Heizdraht in einer Draufsicht auf die Leiterplatte bzw. sind senkrecht zur flächigen Ausdehnung der Leiterplatte beabstandet voneinander übereinander angeordnet.

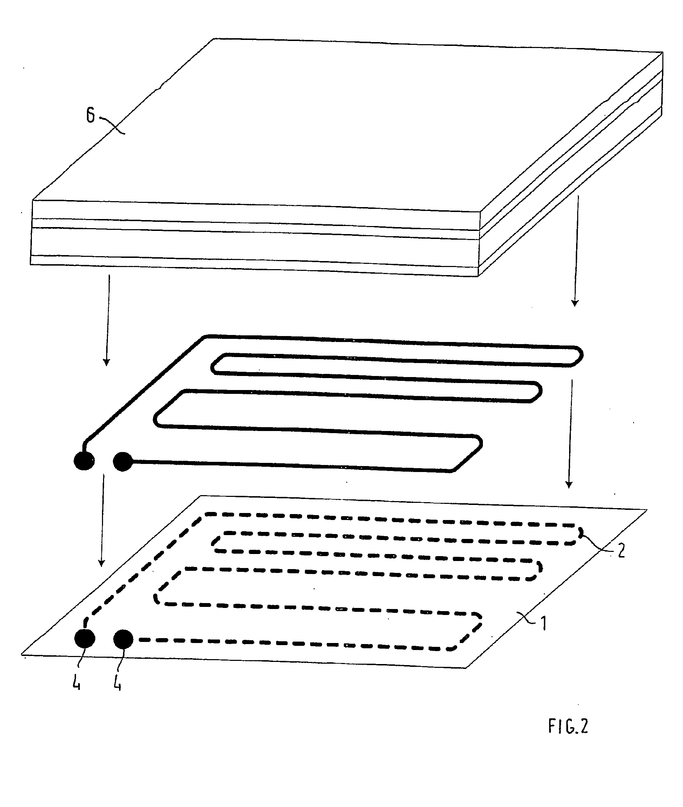

In einem weiteren, in Fig. 2 gezeigten Fertigungsschritt werden die Enden des Heizungswiderstandsdrahts 2 mit beispielsweise zwei an einer Seitenfläche der Leiterplatte 1 angeordneten Anschlussstellen 4 verbunden, vorzugsweise durch Schweißung, über welche eine Verbindung zu einer externen Spannungsquelle geschaffen werden kann. Jedoch kann die Spannungsquelle auch direkt auf der Leiterplatte 1 angeordnet sein, z.B. in Form eines Akkus.Danach wird vorzugsweise eine oder mehrere Deckschichten 6 aus Isolierstoffmasse auf die mit dem Heizungswiderstandsdraht 2 verbundene Leiterplatte 1 aufgebracht, beispielsweise durch Gießen einer aushärtbaren Isolierstoffmasse in eine die Leiterplatte 1 enthaltende Gussform. Hierdurch entsteht ein Verbundkörper 8, bei welchem die Leiterplatte 1 stoffschlüssig mit der Deckschicht 6 verbunden und in einer Verdrahtungsebene dazwischen der Heizungswiderstandsdraht 2 in Position gehalten ist, wie aus Fig. 3 hervorgeht. Der Heizungsdraht ist sozusagen in einer eigenen Schicht angeordnet. Alternativ kann der Heizungsdraht auch nur bereichsweise in der Leiterplatte verlegt sein, um gezielt Baukomponenten zu beheizen.

Besonders bevorzugt erstreckt sich der Heizungswiderstandsdraht 2 im Wesentlichen über die gesamte Fläche der Leiterplatte 1 mäanderförmig. Im vorliegenden Fall ist folglich auf der Leiterplatte 1 eine Kombination einer elektrischen Schaltung in Form von geätzten Leiterbahnen mit einem Heizungswiderstandsdraht 2 verwirklicht. Gemäß einer weiteren Ausführungsform könnte die elektrische Schaltung aber auch durch Leitungsdrähte realisiert sein, welche dann zwischen auf der Leiterplatte 1 angeordneten Anschlussstellen für die elektronischen Bauelemente der Schaltung verlaufen.

Gemäß einer Alternative kann die Ätzung der auf der Oberfläche der Leiterplatte 1 befestigten Kupferfolie auch erst nach dem Verlegen bzw. Drahtschreiben der Heizungswiderstandsdrähte 2 erfolgen, um die Anschlussstellen 4 aus der Kupferfolie herauszuarbeiten. Da diese jedoch gemäß des vorhandenen Schaltungs-Layouts bereits vorab bekannt sind, können die Verbindungen der Heizungswiderstandsdrähte 2 mit den eigentlich noch nicht vorhandenen Anschlussstellen 4 bereits vorab gefertigt werden. Darüber hinaus kann die mit den Heizungswiderstandsdrähten 2 versehene Oberfläche der Leiterplatte 1 dadurch mit der Deckschicht 6 versehen werden, dass ein Prepreg aus Isolierstoffmasse mit der Leiterplatte 1 verpresst wird.

## Patentansprüche

1. Leiterplatte (1) oder Platine mit elektrischer Schaltung, mit zumindest einem auf oder innerhalb der Leiterplatte oder Platine angeordneten elektrisch leitfähigen, mit einer Spannungsquelle in Verbindung bringbaren Heizungsdraht, der durch Drahtschreibung auf der Leiterplatte (1) oder Platine befestigt ist, **dadurch gekennzeichnet, dass** der Heizungsdraht eine elektrische Isolierung aufweist.

2. Leiterplatte (1) oder Platine nach Anspruch 1, **dadurch gekennzeichnet, dass** der Heizungsdraht (2) in einer Verdrahtungsebene zwischen der Leiterplatte (1) oder Platine und einer Schicht (6) aus Isolierstoffmasse angeordnet ist.

3. Leiterplatte (1) oder Platine nach Anspruch 1 oder 2, **dadurch gekennzeichnet, dass** der Heizungsdraht (2) durch einen Widerstandsdraht gebildet wird.

4. Leiterplatte (1) oder Platine nach wenigstens einem der vorhergehenden Ansprüche, **dadurch gekennzeichnet, dass** der Heizungsdraht (2) sich im Wesentlichen über die gesamte Fläche der Leiterplatte oder Platine mäanderförmig erstreckt.

5. Leiterplatte (1) oder Platine nach wenigstens einem der vorhergehenden Ansprüche, **dadurch gekennzeichnet, dass** der Heizungsdraht (2) auf der Leiterplatte (1) oder Platine angeordnete Anschlussstellen (4) für die Spannungsquelle miteinander verbindet.

## Claims

1. Printed circuit board (1) or card with an electrical circuit, having at least one electrically conductive heating wire which is arranged on or inside the printed circuit board or card, can be connected to a voltage source and is fastened on the printed circuit board (1) or card by means of wire writing, **characterized in that** the heating wire is electrically insulated.

2. Printed circuit board (1) or card according to Claim 1, **characterized in that** the heating wire (2) is arranged in a wiring plane between the printed circuit board (1) or card and a layer (6) of insulating compound.

3. Printed circuit board (1) or card according to Claim 1 or 2, **characterized in that** the heating wire (2) is formed by a resistance wire.

4. Printed circuit board (1) or card according to at least one of the preceding claims, **characterized in that** the heating wire (2) extends substantially over the entire surface of the printed circuit board or card in a meandering manner.

5. Printed circuit board (1) or card according to at least one of the preceding claims, **characterized in that** the heating wire (2) connects connection points (4) for the voltage source to one another, which connection points are arranged on the printed circuit board (1) or card.

## Revendications

1. Carte imprimée (1) ou plaquette avec un circuit électrique, avec au moins un fil chauffant qui est conducteur d'électricité, qui est disposé sur ou dans la carte ou la plaquette, qui est apte à être relié à une source de tension et qui est fixé par encastrement sur ladite carte (1) ou plaquette, **caractérisée en ce que** le fil chauffant présente une isolation électrique.

2. Carte imprimée (1) ou plaquette selon la revendication 1, **caractérisée en ce que** le fil chauffant (2) est disposé dans un plan de câblage entre la carte imprimée (1) ou la plaquette et une couche (6) en masse isolante.

3. Carte imprimée (1) ou plaquette selon la revendication 1 ou 2, **caractérisée en ce que** le fil chauffant (2) est formé par un fil de résistance.

4. Carte imprimée (1) ou plaquette selon l'une au moins des revendications précédentes, **caractérisée en ce que** le fil chauffant (2) s'étend globalement sur toute la surface de la carte imprimée ou de la plaquette avec une forme sinueuse.

5. Carte imprimée (1) ou plaquette selon l'une au moins des revendications précédentes, **caractérisée en ce que** le fil de résistance (2) relie entre eux des points de connexion (4) disposés sur la carte imprimée (1) ou la plaquette pour la source de tension.
